# EUROPEAN PATENT APPLICATION

(11) **EP 4 343 765 A1**
(43) Date of publication of application: **27.03.2024**
(21) Application number: 22197499.1
(22) Date of filing: 23.09.2022
(51) Int. Cl.: G11C 11/404, H10B 12/00, G11C 5/06, G11C 7/18, G11C 8/14

(54) **DYNAMIC RANDOM-ACCESS MEMORY DEVICE AND METHOD**

(71) Applicant: IMEC VZW, 3001 Leuven (BE)
(72) Inventor: RASSOUL, Nouredine, 1420 Braine l'Alleud (BE); OH, Hyungrock, 1200 Brussels (BE); DELHOUGNE, Romain, 3150 Haacht (BE); KAR, Gouri Sankar, 3001 Leuven (BE); BELMONTE, Attilio, 1030 Schaerbeek (BE); BANERJEE, Kaustuv, 3001 Heverlee (BE); GUPTA, Mohit, 3001 Heverlee (BE)
(74) Representative: AWA Sweden AB

(57) **Abstract**

A memory device (100) for a DRAM is provided, comprising a first semiconductor device layer (10) comprising a first DRAM bit cell (110) and a second semiconductor device layer (20) comprising a second DRAM bit cell (120). Further, at least one of a first and second interconnecting structure (130, 140) is provided, the first interconnecting structure (130) extending vertically between the first and second semiconductor device layer and being arranged to form a write word line (WWL) common to the gate terminal (113, 123) of the write transistors of the first and second bit cells, and the second interconnecting structure (140) extending vertically between the first and second semiconductor device layer and being arranged to form a read word line (RWL) common to a first source/drain terminal (117, 127) of the read transistors of the first and second bit cells.

## Description

### Technical field

The present inventive concept relates to a memory device for a dynamic random-access memory (DRAM) as well as to a method for forming such a memory device.

### Background

DRAM is a type of random-access memory wherein each bit cell traditionally comprises a capacitor for storing a bit of data and a transistor for accessing the capacitor. The level of charge on the capacitor determines whether that particular bit cell comprises a logical "1" or "0". The bit cells are typically arranged in a twodimensional array, in which each row is connected to a respective word line and each column is connected to a respective bit line. The word lines are used for addressing the bit cells of a specific row, whereas the bit lines are used for reading and writing the data on the individual bit cells of the addressed row.

The strive for reduced bit cell area and increased circuit density has led to a demand for capacitors having a reduced footprint. A particular challenge is associated with the design of the capacitor, since a reduction of the physical dimensions of the capacitor may lead to a reduced capacitance, impairing the operation of the bit cell, as well as increased geometrical complexity, reducing the yield. Another attempt to increase the circuit density has therefore been to introduce the so called capacitorless DRAM, in which the parasitic capacitance of the read transistor serves as the storage element.

However, there is still a need for improved DRAM technologies that allow for further reduction of the memory cell area without impairing the performance, manufacturability and function of the DRAM device.

### Summary of the inventive concept

An objective of the present inventive concept is accordingly to provide a memory device for a DRAM which allows for further reduction of the memory cell area without impairing the performance and function of the DRAM device. Additional and alternative objectives may be understood from the following.

According to an aspect of the present inventive concept, there is provided a memory device for a DRAM, comprising a substrate supporting a first semiconductor device layer comprising a first DRAM bit cell, and a second semiconductor device layer comprising a second DRAM bit cell, wherein the first semiconductor device layer is arranged between the substrate and the second semiconductor device layer. Each bit cell includes a write transistor and a read transistor, wherein a first source/drain terminal of the write transistor is connected to a gate of the read transistor to form a storage node of the bit cell. The memory device further comprises at least one of a first interconnecting structure extending vertically between the first and second semiconductor device layer and being arranged to form a write word line common to the gate terminal of the write transistors of the first and second bit cells, and a second interconnecting structure extending vertically between the first and second semiconductor device layer and being arranged to form a read word line common to a first source/drain terminal of the read transistors of the first and second bit cells.

By stacking bit cells above the substrate, the area efficiency of the memory device is improved, since a vertical stacking direction provides an additional scaling path compared to conventional planar memory arrays. Further, the stacked configuration allows the terminals of each bit cell of the resulting DRAM to be accessed in a more efficient manner, as some of the terminals can be merged. While the read and write word lines are common along the vertical axis but isolated within each device layer, the design further allows the read and write bit lines to be common to horizontal rows of bit cells and vertically isolated between the device layers. The word lines can hence be arranged orthogonally to the bit lines to more efficiently utilise the available cell area compared to conventional planar memory arrays, or planar memory arrays that are monolithically stacked on top of each other.

The substrate supports the first and second semiconductor device layer in which the bit cells are formed or implemented. The device layers extend laterally or horizontally along a main surface of the substrate. The device layers may be referred to as a back end of line (BEOL) portion of the substrate or the memory device.

The write transistor of each bit cell may be a field-effect transistor (FET). In particular, the write transistor may be an n-type FET.

The read transistor of each bit cell may be a FET. In particular the read transistor may be an n-type FET.

The charge storage element of each bit cell may be formed by a parasitic capacitive coupling between a terminal of the write transistor, such as the drain, and a terminal of the read transistor, such as the gate.

As used herein, the term DRAM refers to a memory wherein data are stored by predetermined levels of charges by a capacitive charge storage element of each bit cell. In the "read mode", one or more bit cells are accessed in order to read out data stored by the bit cells. Conversely, in the "write mode" one or more bit cells are charged to a predetermined high voltage level (e.g. to store a "1") or a predetermined low voltage level (e.g. to store a "0") in order to write data to be stored by the bit cell.

According to an embodiment, each semiconductor layer of the memory device comprises a plurality of bit cells and a horizontal read bit line RBL interconnecting the read transistors of each bit cell.

According to a further embodiment, each semiconductor layer comprises a horizontal write bit line WBL interconnecting the write transistors of each bit cell.

The read bit line of the first semiconductor device layer is electrically insulated from the read bit line of the second semiconductor layer. Correspondingly, the write bit line of the first semiconductor device layer may be electrically insulated from the bit line of the second semiconductor device layer.

According to an embodiment, the write transistor and the read transistor are metal-oxide semiconductor FETs, MOSFETs. As realised by the inventors, metal-oxide transistors lend themselves for integration in the BEOL portion (i.e., being implemented in materials which may be processed within the reduced thermal budget available during BEOL-processing). Such transistors are associated for their relatively low off-state leakage and their BEOL compatibility. The fabrication of such devices can take the advantage of the vertical dimension to enable a high system scalability along the vertical axis.

According to an aspect, there is provided a method for forming a memory device for a DRAM comprising a first and a second bit cell, each bit cell comprising a write transistor and a read transistor, wherein a first source/drain terminal of the write transistor is connected to a gate of the read transistor to form a storage node of the bit cell. The method comprises forming a first trench and a second trench, parallel to the first trench, in a stacked layer structure comprising a first sub-stack and a second sub-stack of layers and in the first trench, forming the write transistor of each sub-stack by laterally recessing layers of the sub-stack and forming, in the recesses, a channel structure, a gate dielectric and gate metal of the write transistor. The method further comprises forming the write word line in the first trench to interconnect the gate terminal of the write transistors of the first and second bit cells, in the second trench, forming the read transistor of each sub-stack by laterally recessing layers of the sub-stack and forming, in the recesses, a channel structure and a gate dielectric of the read transistor, and an isolating layer, and forming the read word line in the second trench to interconnect the first source/drain terminal of the read transistor of the first and second bit cells.

According to an embodiment, lateral recesses are formed from the first trench and a from the second trench. Each device layer is provided with a recess from the trenches on both sides of the layer. Thereafter, the recesses formed from the first trench are filled with a conductive material to form the horizontal read bit line RBL, whereas the recesses formed from the second trench are filled a conductive material to form the horizontal write bit line WBL. For each sub-stack, the RBL may be arranged to interconnect the read transistors of each of the plurality of bit cells and the WBL arranged to interconnect the write transistors of each of the plurality of bit cells.

The method outlined above generally provides the same or corresponding advantages as those discussed in connection with of the memory device. Reference is therefore made to the above discussion concerning advantages associated with the memory device, but also to the above discussion of details, embodiments and optional features with respect to the memory device, which apply correspondingly to the method as outlined above.

### Brief description of the drawings

The above, as well as additional objects, features and advantages of the present inventive concept will be better understood through the following illustrative and non-limiting detailed description of preferred embodiment of the present inventive concept, with reference to the appended drawings. In the drawings like reference numerals will be used for like elements unless stated otherwise.
Figure 1 is a schematic illustration of the layout of a memory device according to an embodiment.
Figure 2 is a schematic illustration of a write transistor and a read transistor forming a bit cell of a memory device according to an embodiment.
Figures 3a and are vertical cross sections through a read transistor and a write transistor, respectively, according to an exemplary transistor layout.
Figure 4 illustrate a stack of semiconductor layers comprising a first and a second sub-stack, from which a memory device according to an embodiment is formed.
Figure 5-14 show the memory device at different stages of the manufacturing of the device.
Figures 15a-c show cross sections taken through different portions of a memory device according to an embodiment.

### Detailed description of preferred embodiments

Detailed embodiments of the present inventive concept will now be described with reference to the drawings. The present inventive concept should not be construed as limited to the embodiments set forth herein. Rather, these embodiments are provided by way of example so that this disclosure will convey the scope of the inventive concept to those skilled in the art.

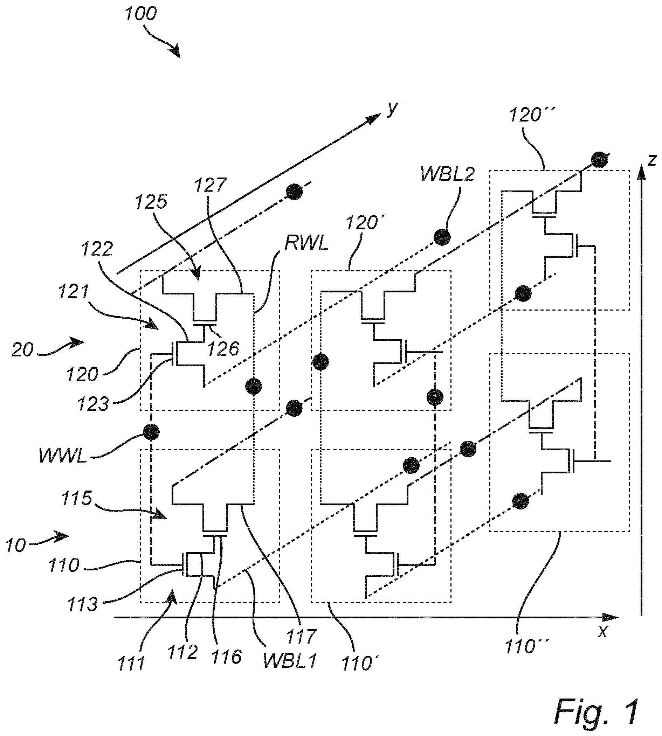

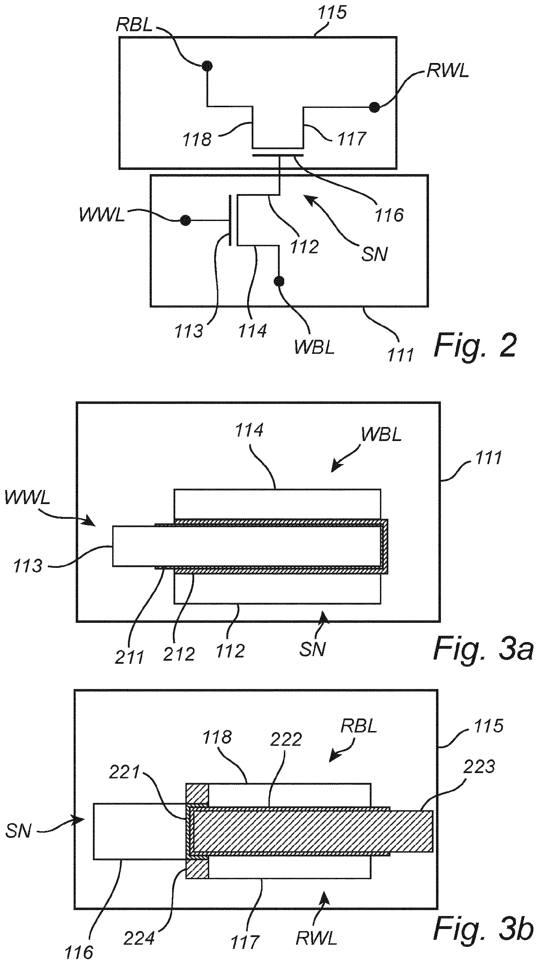

With reference to figure 1, there is shown a memory device 100 for a dynamic random-access memory, DRAM. The device 100 in figure 1 comprises a plurality of stacked bit cells 110, 120 arranged above each other in horizontal semiconductor device layers 10, 20, wherein the bit cell 120 represents a top-most bit cell of the stack and the bit cell 110 represent a bottom bit cell of the stack. The bit cells 110, 120 and the semiconductor device layers 10, 20 are arranged in or between different metallization levels of a back end of line, BEOL, portion of the device 100. The layout of an example of such a bit cell 110 is illustrated in greater detail in figure 2.

Figure 1 schematically shows the layout of the memory device 100, and it is appreciated that only portions of the semiconductor device layers 10, 20 forming part of the structure are shown and that the layers may extend laterally/horizontally beyond the illustrated portions. It should also be noted that for the purpose of clarity the various layers and other features of the stacks are not drawn to scale in the appended drawings, and that their relative dimensions, in particular their thickness, may differ from a physical stack. Further, as indicated in figure 1, it should be understood that the device 100 may comprise a plurality of bit cells 110', 110", 120', 120" arranged in three-dimensional bit cell arrays.

As shown in figure 2, a bit cell 110 comprises a charge storage node SN, a write transistor 111 and a read transistor 115. The charge storage node SN is formed by a source/drain electrode 112 of the write transistor 111 and the gate 116 electrode of the read transistor 115, which are formed, or interconnected, by a common structure providing a parasitic capacitance that can be used to temporarily store a charge representing a logic state of the bit cell 110. The charge storage node SN may hence function as a capacitor, and the capacitance associated with the node provided by means of the parasitic capacitance of the layout of the memory device 100.

The write transistor 111 and the read transistor 115 of each bit cell 110 may be formed at the same metallization level in the BEOL portion, e.g., in a dielectric layer between the metallization layers of adjacent metallization levels. It will however be appreciated that the write and read transistors 111, 115 in some examples are formed at different levels.

As shown in figure 1, each write transistor 111, 121 comprises a gate electrode 113, 123 connected to a write select line or write word line WWL for addressing or selecting those specific write transistors 111, 121 during a write operation. The write word line WWL is common to the vertically stacked write transistors 111, 121, and therefore extends vertically between the bit cells 110, 120 in the first and second semiconductor device layers 10, 20. Each write transistor 111, 121 further comprises a first electrode and a second electrode forming source/drain electrodes 112, 114, 122, 124 of the transistor 111, 121. One of the electrodes 112, 122 of the write transistor 111, 121, such as the first one, may be connected to the gate electrode 116, 126 of the read transistor 115, 125 of the bit cell 110, 120, whereas the other one of the electrodes 114, 124 (such as the second one) may be connected to a write bit line WBL1, WBL2. Thus, the write voltage required for charging the storage node SN is provided from the write bit line WBL via the write transistor 111, 121 in its selected, or closed state (i.e., conducting state). As illustrated in the exemplifying embodiment of figure 1, the vertically stacked bit cells 110, 120 may be commonly addressed by the common word line WWL and written using separate write bit lines WBL1, WBL2.

Each read transistor 115, 125 may, as already mentioned, comprise a gate electrode 116, 126 that is connected to the first electrode 112, 122 of the write transistor 111, 121 of the bit cell 110, 120. In the present example, the first electrode 112, 122 is connected to the drain of the of the write transistor 111, 121. The other electrodes of the read transistor 115, 125, that is, the first electrode 117, 127 and the second electrode 118, 128, forming source/drain electrodes of the read transistor 115, 125, are connected to a read word line RWL and a read bit line RBL1, RBL2, respectively. In the example in figure 1 the read word line RWL is common to the read transistors 115, 125 in the stack, thereby extending vertically between the first and second semiconductor device layers 10, 20. In its closed or conducting state, the read transistor 115, 125 allows a read current to flow between the read common word line RWL and a read bit line RBL1, RBL2, respectively, thereby allowing charging or discharging of the read word line RWL. Charging or discharging of the read word line RWL may be sensed and interpreted as a logic state, that is, a logic "1" or "0".

The read word line RWL of a stack may be connected to a gain transistor (not shown), which may be common to the bit cells 10, 20 of each stack and configured to amplify the read-out signal and transmit it to a common or global read bit line of the DRAM.

The write transistor 111 and the read transistor 115 in the bit cell illustrated in figure 2 may be a FET, e.g. an n-type FET, produced in one or several a metallization levels of the BEOL portion of the memory device, as will be further described in the exemplary process flow below. It will be appreciated that the channel material may differ from the two transistor types, such that the write transistor 111 comprises channel material that is different from the one of the read transistor 115. The channel material(s) may be selected based on the required performance of the respective transistors 111, 115. In an example, a wide band gap semiconductor material may be selected for the write transistor 111, such as a metal oxide semiconductor or doped metal semiconductor material (IGZO, IZO or the like). For the read transistor, the channel material may be formed of Si, Poly-Si, ITO, a 2D material, a metal oxide semiconductor or a doped metal oxide semiconductor material.

Figures 3a and b are vertical cross sections of a write transistor (figure 3a) and a read transistor (figure 3b) according to some embodiments of the inventive concept. The transistors may be similarly configured as the write transistors 111, 121 and read transistors 115, 125, respectively, discussed above in connection with figures 1 and 2. Hence, the memory device 100 and bit cells 110, 120 in figures 1 and 2 may be realized using the exemplary transistors in figures 3a and b.

Figure 3a shows a write transistor 111 comprising a first electrode 112 and a second electrode 114 forming source/drain of the transistor 111. In the present example, the first electrode 112 forms the drain and the second electrode 114 the source of the transistor 111. The source and drain electrodes 112, 114 are vertically stacked above each other, with a gate electrode 113 arranged in between. The resulting structure is thus a layered stack, with the drain electrode 112 at the bottom, the gate electrode 113 in the middle and the source electrode 114 on the top.

To form the active device, a gate dielectric layer 211 is formed on the gate electrode 113. The gate dielectric layer 211 may be arranged to at least partly enclose the gate electrode 113. In the present figure, the gate dielectric layer 211 is provided at the interface to the drain electrode 112 and the source electrode 114, as well as on a vertical end surface of the gate electrode 113 (to the right in figure 3a). As further illustrated in the figure, the channel region is formed by a channel layer 212 arranged on the dielectric layer 211. As mentioned above, the gate electrode 113 is connected to the write word line WWL and used for arranging the write transistor in its closed or conducting state, in which a write voltage is provided from the write bit line WBL connected to the source electrode 114 to the storage note SN formed by the drain electrode 112.

Figure 3b shows a read transistor 121 comprising a first electrode 117 and a second electrode 118 forming source/drain of the transistor 121. The source and drain electrodes 117, 118 are vertically stacked above each other, with an isolating layer 223 arranged in between. The resulting structure is thus a layered stack, with the first source/drain electrode 117 at the bottom, the isolating layer 223 in the middle and the second source/drain electrode 118 on the top. The gate electrode 116 is in this example arranged to the side of this stacked structure (to the left in figure 3b), with the gate dielectric layer 221 and the channel region 222 arranged between the source/drain electrode stack and the gate electrode 116. The gate dielectric layer 221 is arranged at least at a vertical interface between the isolating layer 223 and the gate electrode 116, whereas the channel region is formed by a channel layer 222 deposited on the isolating layer 223. In the present example, the channel layer 223 is provided in the horizontal interfaces between the isolating layer 223 and the first and second source/drain electrodes 117, 118, as well as in the vertical interface between the gate dielectric layer 221 and the end surface of the isolating layer 223. Further, a spacer structure 224 is provided to physically separate the gate electrode 116 and the source/drain electrodes 117, 118.

To form the active device, a gate dielectric layer 211 is formed on the gate electrode 113. The gate dielectric layer 211 may be arranged to at least partly enclose the gate electrode 113. In the present figure, the gate dielectric layer 211 is provided at the interface to the drain electrode 112 and the source electrode 114, as well as on a vertical end surface of the gate electrode 113 (to the right in figure 3a). As further illustrated in the figure, the channel region is formed by a channel layer 212 arranged on the dielectric layer 211. As mentioned above, the gate electrode 113 is connected to the write word line WWL and used for arranging the write transistor in its closed or conducting state, in which a write voltage is provided from the write bit line WBL connected to the source electrode 114 to the storage note SN formed by the drain electrode 112.

The gate electrode 116 is formed by the same structure, or element, as the drain electrode 112 in figure 3a. The gate electrode 116 of the read transistor 115 and the drain electrode 112 of the write transistor 111 may hence extend in the same horizontal layer of the memory device 100, forming the charge storage node SN of the bit cell 110. The first source/drain electrode 117 is in the present example connected to the read word line RWL, whereas the second source/drain electrode 118 is connected to the read bit line RBL. In its closed or conducting state, the read transistor 115 allows a read current to flow between the read word line RWL and the read bit line RBL, thereby allowing charging or discharging of the read word line RWL.

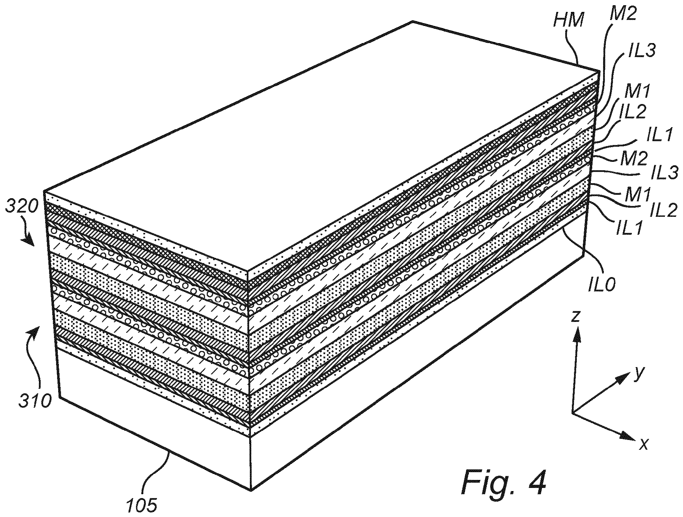

An exemplary process for forming the write and read transistors 111, 115 in figures 3a and b, as well as a memory device 100 in figure 1, will now be disclosed with reference to figures 4-15c, showing the result of various process modules.

Figure 4 shows a semiconductor substrate 105 supporting a first and a second sub-stack 310, 320 of layers, into which the memory device is to be formed. In some examples, the first and second sub-stacks 310, 320 may be arranged on a peripheral device instead of a substrate 105. In the example of figure 4, the first bit cell 110 is formed in the first sub-stack 310, whereas the second bit cell 120 is formed in the second sub-stack 320, arranged above the first sub-stack 310. In the exemplary embodiment shown in figure 4, each sub-stack 310, 320 comprises the following layers (in a bottom-top order): a first isolating layer structure IL1 of a SiCN layer on top of a SiN layer IL0, a second isolating layer IL2, a first conductive layer or metal layer M1 of Ru, and a third isolating layer structure IL3 of a a-Si layer and a TiN layer. Further, a second metal layer M2 is formed above the third isolating layer structure IL3. Finally, a hard mask layer HM of e.g. Al₂O₃ is arranged on top of the second sub-stack 320. It will be appreciated that this is an illustrating example of how to realise the inventive concept, and that other materials and material combinations also are possible.

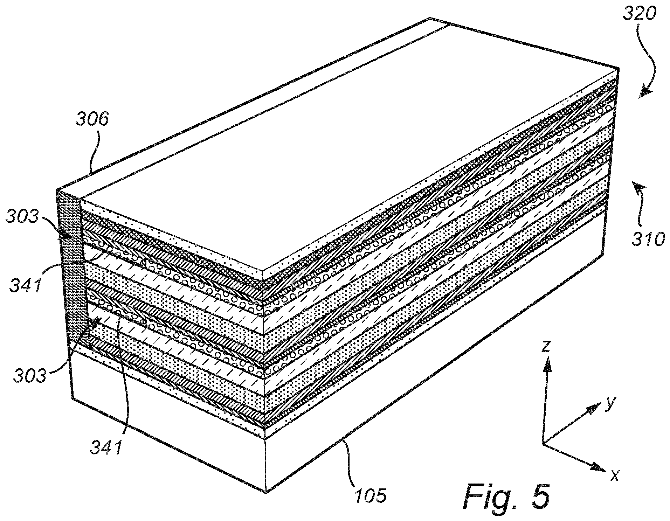

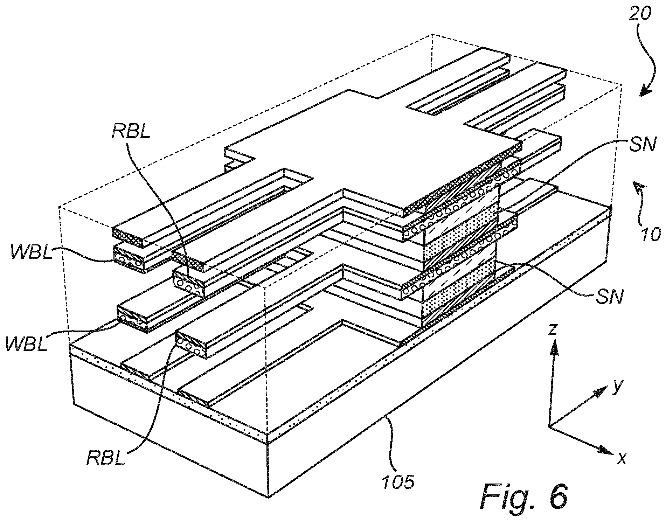

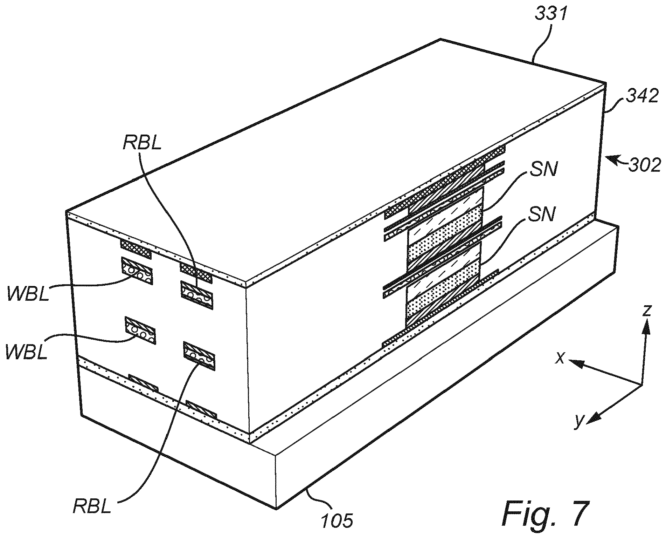

In figure 5, a vertical trench has been etched into the stacked layer structure, through the first and second sub-stacks 310, 320. For each sub-stack 310, 320, the TiN barrier layer has been laterally recessed from the vertical trench to form a recess 303 that is lined with an insulating layer 341. In some examples, the TiN barrier layer may be replaced by the second metal layer M2. A metal barrier and fill layer may then be deposited on the insulating layer 341. The present processing module aims at isolating the future read bit lines RBL and write bit lines WBL, extending horizontally along each sub-stack 310, 320 as indicated in e.g. figures 6 and 7.

Figure 6 shows the result of a processing module aiming at forming the continuous metal lines along the γ-axis, i.e., the read bit lines RBL and write bit lines WBL, at each semiconductor device level. Further, the module aims at isolating the charge storage nodes SN of the bit cells, as well as layers that will be recessed later during the processing of the memory device.

In a first step, vertical trenches are etched through the entire stack, that is, through the first and second sub-stacks 310, 320. The vertical trenches may for example be patterned using a dual patterning technique. Thereafter, the second metal layer M2, the third insulating layer IL3 and the first insulating layer IL1 are laterally recessed to define the regions from which the charge storage nodes SN are to be formed. In the resulting structure shown in figure 6, each device level 10, 20 comprises two parallel metal lines from which the read and write bit lines RBL, WBL are to be formed, as well as the layers from which the write and read transistor 111, 115 of each bit cell will be formed.

Figure 7 is a rotated view, showing the side of the structure facing away from the viewer in figure 6. As shown in the present figure, the trenches and recesses has been filled with an isolating material 342, such as SiO2, and a vertical trench 302, similar to the vertical trench in figure 5, etched into the stacked layer structure, through the first and second sub-stacks 310, 320, using the mask layer 331 as an etch mask. The vertical trench 302 is arranged to expose the sidewalls of the regions formed in figure 6, in which the write and read transistors 111, 115 are to be formed.

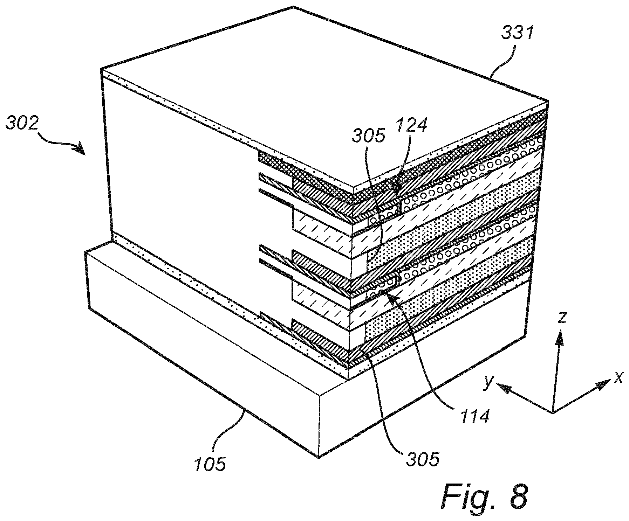

Figure 8 is a perspective view of the structure as seen from the trench 302 and of a cross section taken trough the y-axis. Here, the first metal layer M1 has been laterally recessed, followed by a deposition of an insulator 305, such as SiO₂, and an etch-back process.

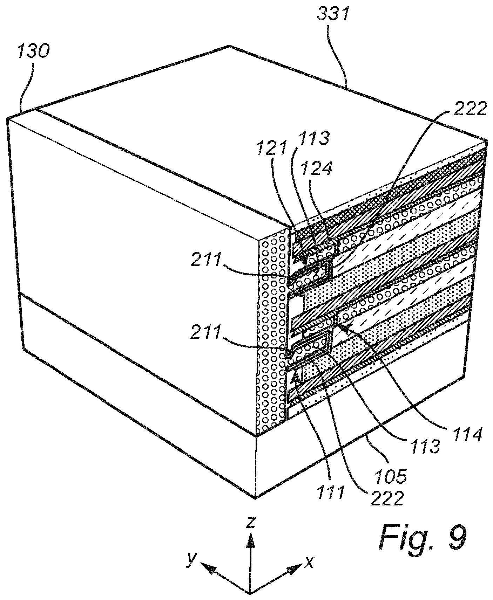

In figure 9, the third insulating layer IL3 has been recessed to form recesses in which the write transistors 111, 121 are defined by depositing the channel layer 212, the gate dielectric layer 211 and eventually the gate electrode 113. The gate electrode material fills the remaining parts of the lined recesses 305 and also forms the interconnecting structure 130 extending vertically in the vertical trench, forming a common write word line WWL interconnecting the gate terminal 113, 123 of the write transistors of the first and second bit cells 110, 120.

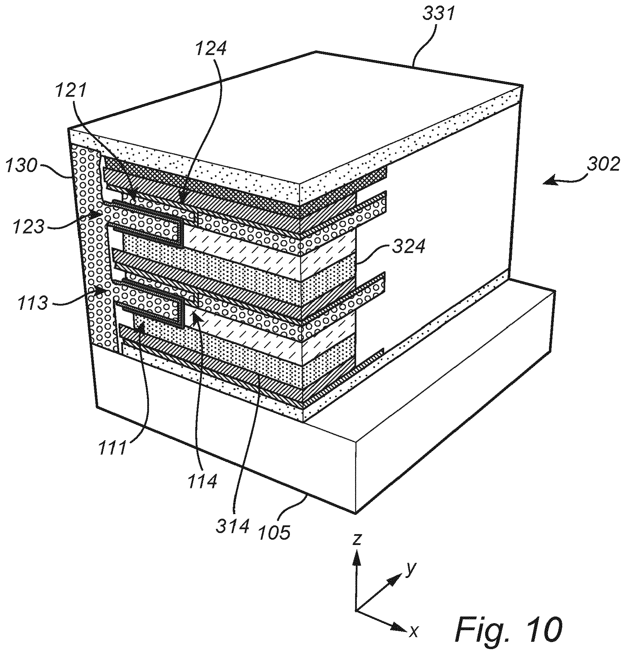

In figure 10, a second vertical trench 302, parallel to the trench in which the first interconnecting structure 130 is arranged, has been etched into the stacked structure to expose the sidewalls of the layers in which the read transistors 115, 125 are to be formed.

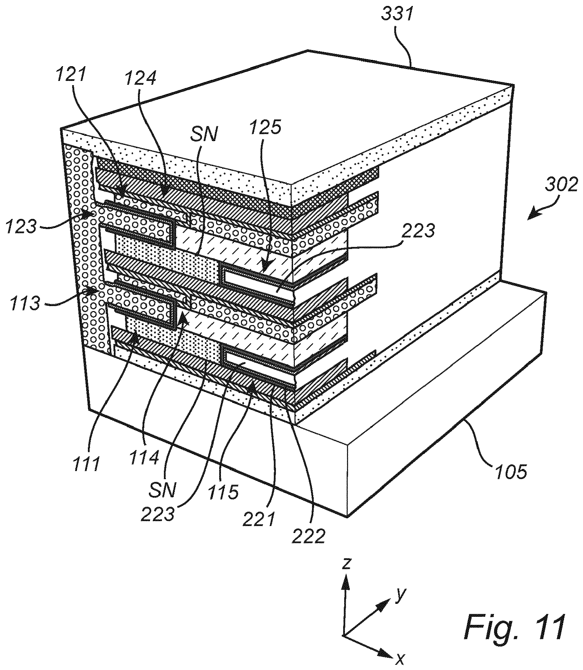

To form the read transistors 115, 125, the second vertical trench 302 is used for forming lateral recesses in the Ru layer 314, arranged below the a-Si and SiCN layers in which the gate electrodes 113, 123 of the write transistors 111, 125 are formed on the opposite side of the stack, via the first vertical trench 301. A gate dielectric layer 221 and a channel layer 222 are deposited in the recesses, which then are filled with an isolating layer 223, such as SiO₂. The resulting structure is shown in figure 11.

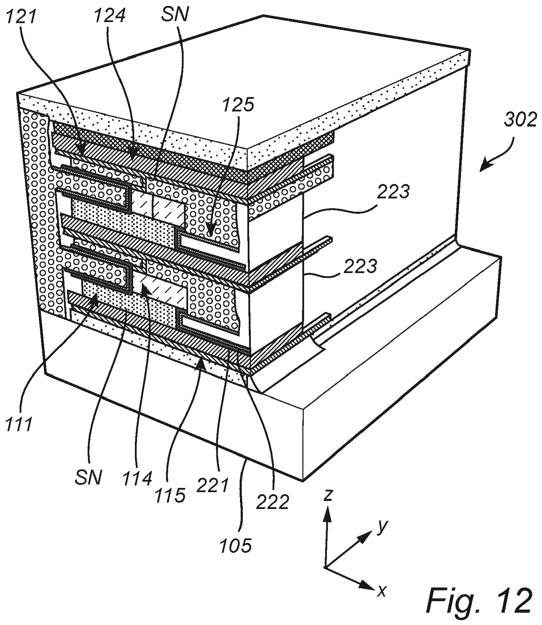

In figure 12 the second vertical trench 302 has been used to laterally recess the third insulating layer IL3 and etching the gate dielectric layer 221. A metallization coupled with a lateral metal recess can then be operated to form the source of the read transistor. Thereafter, after a filling and etch-back of an isolating material such as SiO₂ is performed to electrically isolate the source and drain of this read transistor. The drain of the read transistor is formed by a first lateral recessing of the second insulating layer IL2 followed by etching the gate dielectric layer 221 and a metallization process similar to then one forming the source, with the difference that no-etch back of the metal is performed in order to maintain a source-common vertical metal along the read transistors along the z-axis.

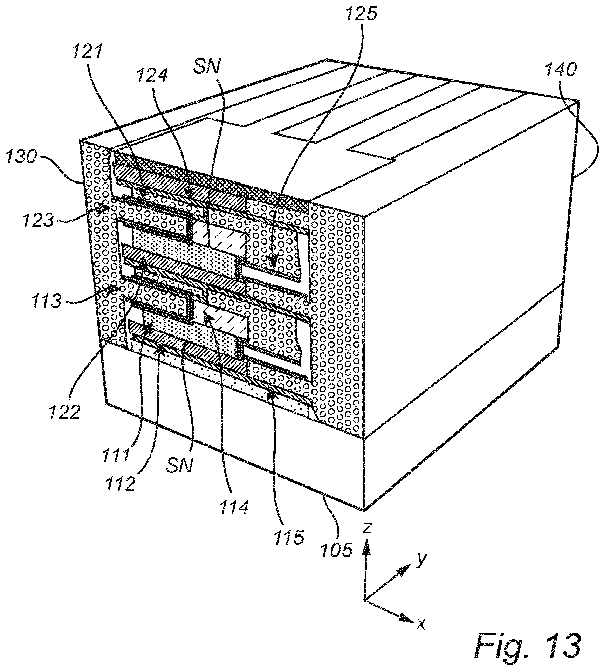

In figure 13 the SiN layer and the gate dielectric layer 221 have been laterally recessed, followed by a deposition of TiN to form the second interconnecting structure 140 extending vertically between the first and second read transistors 115, 125. As illustrated in figure 13 the two sub-stacks 310, 320 have now been processed to form a respective bit cell, each comprising a write transistor 111, 121 and a read transistor 115, 125. The gate electrodes 113, 123 of the write transistors 111, 121 are interconnected by the vertically arranged interconnecting structure 130, whereas drain electrodes 112, 122 of the write transistors 111, 121 are connected to the gate electrodes 116, 126 of the read transistors 115, 125 via the storage node SN. A first one of the source/drain electrodes of the read transistors 115, 125 are in turn interconnected by the second interconnecting structure 140.

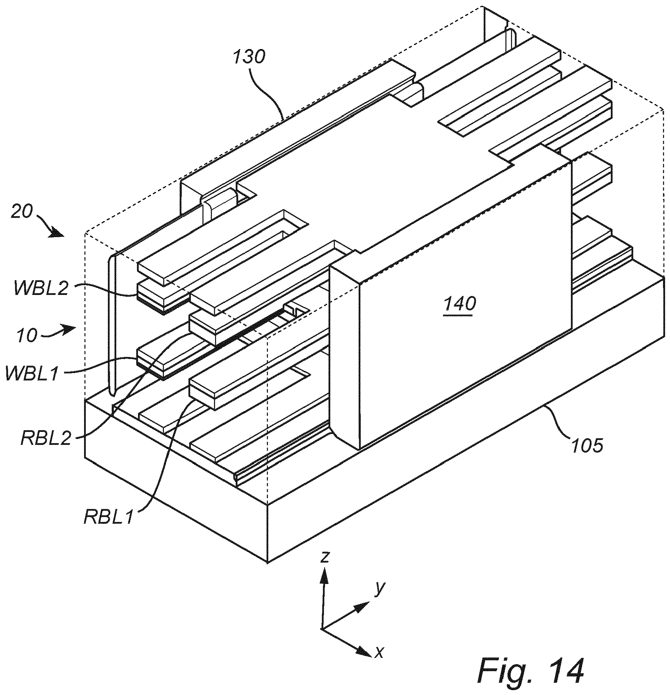

Figure 14 is a perspective view of the memory device 100 formed in the above-described processing steps and modules. The first and second vertically oriented interconnecting structures 130, 140 are shown on opposite sides of the stacked bit cells, with respect to the x-axis. In the orthogonal direction, i.e., along the γ-axis, the bit lines are formed in the two semiconductor device layers 10, 20. The first write bit line WBL1 and the first read bit line RBL1 extend in parallel in the first semiconductor device level 10, whereas the second write bit line WBL2 and the second read bit line RBL2 are arranged between each other in the second semiconductor device layer 20.

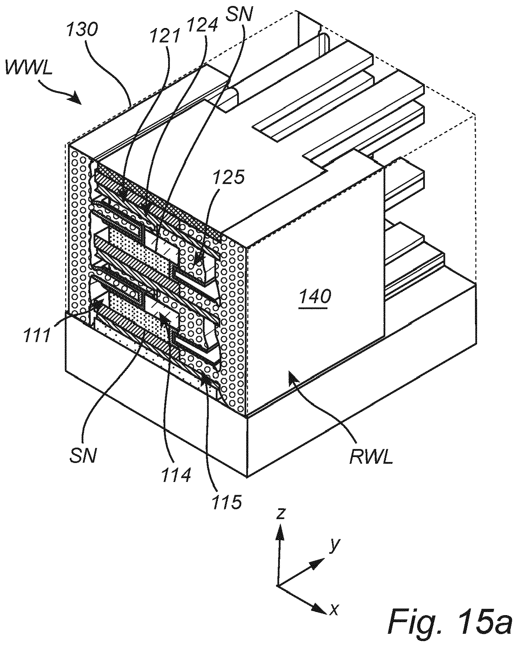

Figures 15a-c show different cross sections of the memory device 100 in figure 14. Figure 15a is a cross section through the γ-axis, showing the orientation of the first and second write transistors 111, 121 in relation of the first and second read transistors 115, 125 and the storage node SN defined therebetween. The first interconnecting structure 130 forms the write word line WWL, which hence is common to both write transistors 111, 121 of the stacked bit cells. In a trench opposite the first interconnecting structure 130 the second interconnecting structure 140 is arranged, forming the read word line RWL, which is common to the two read transistors 115, 125 of the memory device 100.

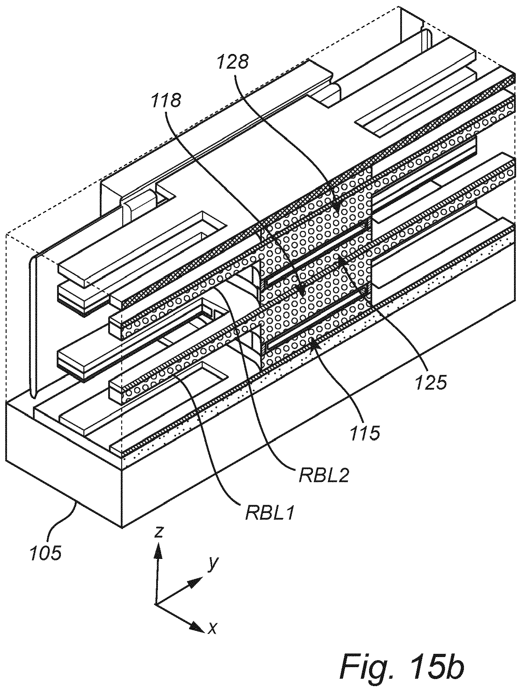

Figure 15b is a cross section through the x-axis and the read transistors 115, 125, illustrating the first and second read bit lines RBL1, RBL2 which are vertically separated from each other and extending horizontally along the y-axis. The first read bit line RBL1 is connected to a source/drain electrode 118 of the first read transistor 115 whereas the second read bit line RBL2 is connected to a source/drain electrode 128 of the second read transistor 125.

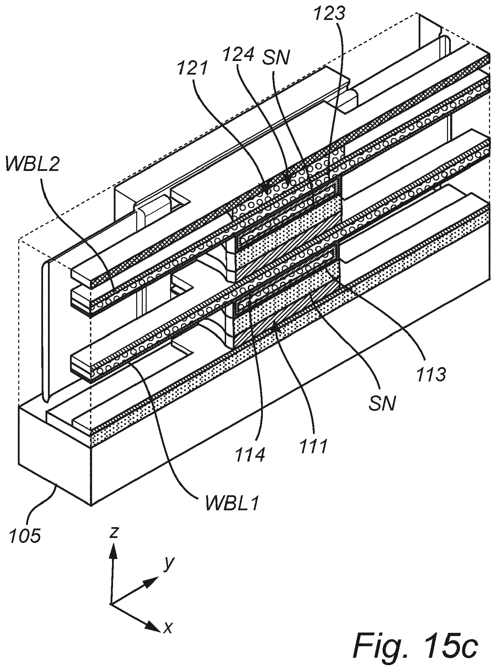

Figure 15c is a similar cross section as in figure 15b, taken through the write transistors 111, 121 instead. In the present figure, the first and second write bit lines WBL1, WBL2 are illustrated, extending horizontally along the y-axis and being vertically isolated from each other. The first write bit line WBL1 is connected to source/drain electrode 114, such as the source, of the first write transistor 111 and the second write bit lines WBL2 to source electrode 124 of the second write transistor 121. Further, a cross section of the storage node SN is also shown, arranged below the source electrode 114, 124 and the gate electrode 113, 123 of the write transistors 111, 121.

## Claims

1. A memory device (100) for a dynamic random-access memory, DRAM, comprising:
a substrate (105) supporting a first semiconductor device layer (10) comprising a first DRAM bit cell (110), and a second semiconductor device layer (20) comprising a second DRAM bit cell (120), wherein the first semiconductor device layer is arranged between the substrate and the second semiconductor device layer;
wherein each bit cell includes a write transistor (111, 121) and a read transistor (115, 125), wherein a first source/drain terminal (112) of the write transistor is connected to a gate (116, 126) of the read transistor to form a storage node (SN) of the bit cell; and
wherein the memory device comprises at least one of:
a first interconnecting structure (130) extending vertically between the first and second semiconductor device layer and being arranged to form a write word line (WWL) common to the gate terminal (113, 123) of the write transistors of the first and second bit cells, and
a second interconnecting structure (140) extending vertically between the first and second semiconductor device layer and being arranged to form a read word line (RWL) common to a first source/drain terminal (117, 127) of the read transistors of the first and second bit cells.

2. The memory device according to claim 1, wherein each semiconductor device layer comprises a plurality of bit cells and a horizontal read bit line (RBL) interconnecting the second source/drain terminal (118, 128) of the read transistors of each bit cell.

3. The memory device according to claim 2, wherein each semiconductor layer further comprises a horizontal write bit line (WBL) interconnecting the second source/drain terminal (114, 124) of the write transistors of each bit cell.

4. The memory device according to claim 2, wherein the read bit line of the first semiconductor device layer is electrically insulated from the read bit line of the second semiconductor device layer.

5. The memory device according to claim 3, wherein the write bit line of the first semiconductor device layer is electrically insulated from the write bit line of the second semiconductor device layer.

6. The memory device according to any of the preceding claims, wherein the write transistor and the read transistor are metal-oxide semiconductor field-effect transistors, MOSFETs.

7. The memory device according to any of the preceding claims, wherein:
the first bit cell is formed in a first sub-stack of layers and the second bit cell is formed in a second sub-stack of layers;
for each sub-stack, the first source/drain terminal of the write transistor is formed in a same layer of the sub-stack as the gate of the read transistor;
the write word line (WWL) is arranged in a first trench, extending vertically into the first and second sub-stacks, to electrically interconnect the gate terminal of the write transistors of the first and second bit cells; and
the read word line (RWL) is arranged in a second trench, extending vertically into the first and second sub-stacks and being parallel to the first trench, to electrically interconnect the first source/drain terminal of the read transistors of the first and second bit cells.

8. A method for forming a memory device for a dynamic random-access memory, DRAM, comprising a first and a second bit cell, each bit cell comprising a write transistor and a read transistor, wherein a first source/drain terminal of the write transistor is connected to a gate of the read transistor to form a storage node of the bit cell, the method comprising:
forming a first trench (301) and a second trench (302), parallel to the first trench, in a stacked layer structure comprising a first sub-stack (310) and a second sub-stack (320) of layers;
in the first trench, forming the write transistor (111, 121) of each sub-stack by laterally recessing layers of the sub-stack and forming, in the recesses (303), a channel structure (212), a gate dielectric (211) and gate metal (113) of the write tra nsistor;
forming the write word line (WWL) in the first trench to interconnect the gate terminal of the write transistors of the first and second bit cells;
in the second trench, forming the read transistor (115, 125) of each sub-stack by laterally recessing layers of the sub-stack and forming, in the recesses (304), a channel structure (222) and a gate dielectric (211) of the read transistor, and an isolating layer (223); and
forming the read word line (RWL) in the second trench to interconnect the first source/drain terminal of the read transistor of the first and second bit cells.

9. The method according to claim 8, further comprising:
for each sub-stack, forming a first lateral recess from the first trench and a second lateral recess from the second trench;
filling the first lateral recess with a conductive material to form a horizontal read bit line (RBL) for connecting the read transistor; and
filling the second lateral recess with a conductive material to form a horizontal write bit line (WBL) for connecting the write transistor.

10. The method according to claim 9, wherein:
each sub-stack comprises a plurality of bit cells;
the horizontal read bit line is arranged to interconnect the read transistors of each of the plurality of bit cells; and
the horizontal write bit line is arranged to interconnect the write transistors of each of the plurality of bit cells.
